(19) Europäisches Patentamt
European Patent Office
Office européen des brevets

(11) **EP 1 796 231 A2**

(12) **EUROPEAN PATENT APPLICATION**

(43) Date of publication:
**13.06.2007 Bulletin 2007/24**

(51) Int Cl.:
**H01S 5/14** *(2006.01)*

(21) Application number: **06125505.5**

(22) Date of filing: **06.12.2006**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(30) Priority: **09.12.2005 KR 20050121038
08.02.2006 KR 20060012026**

(71) Applicant: **ELECTRONICS AND
TELECOMMUNICATIONS RESEARCH
INSTITUTE
Daejeon (KR)**

(72) Inventors:
• **Kwon, Oh Kee**
  **Daejeon-city (KR)**
• **Kim, Kang Ho**
  **Daejeon-city (KR)**
• **Kim, Jonghoi**
  **Daejeon-city (KR)**
• **Sim, Eundeok**
  **Daejeon-city (KR)**
• **Oh, Kwang Ryong**
  **Daejeon-city (KR)**

(74) Representative: **Betten & Resch
Theatinerstrasse 8
80333 München (DE)**

(54) **Wavelength tunable light source**

(57) Provided is a wavelength tunable light source including a semiconductor optical amplifier, a beam steering unit or a beam deflector, and a concave diffraction grating integrated therein. The wavelength tunable light source can be easily implemented since locations to which a beam is diffracted by the concave diffraction grating and at which portions of the beam with different wavelengths have constructive interference form a straight line, not a Rowland circle. Furthermore, wavelength tuning and optical coupling characteristics of the wavelength tunable light source are excellent. Since both single integration and hybrid integration are possible for the wavelength tunable light source, the wavelength tunable light source exhibits superior operating characteristics and high reliability.

FIG. 7

EP 1 796 231 A2

**Description**

BACKGROUND OF THE INVENTION

This application claims the priority of Korean Patent Application No. 10-2005-0121038, filed on December 9, 2005 and Korean Patent Application No. 10-2006-0012026, filed on February 8 2006, in the Korean Intellectual Property Office, the disclosures of which are incorporated herein in their entirety by reference.

1. Field of the Invention

The present invention relates to a wavelength tunable light source, and more particularly, to a wavelength tunable light source having a semiconductor optical amplifier (SOA), a beam steering unit or a beam deflector, and a concave diffraction grating integrated therein.

2. Description of the Related Art

Wavelength tunable semiconductor lasers (wavelength tunable light sources) use an optical transmission method such as a wavelength division multiplexing method. Wavelength tunable semiconductor lasers can not only replace wavelength-fixed semiconductor lasers generating different wavelengths, but also have a wide and diverse range of applications. For example, wavelength tunable semiconductor lasers are actively used in reconfigurable optical add/drop multiplexers (ROADMs), fast packet switching in all-optical networks, wavelength converters, and wavelength routing. In addition, wavelength tunable semiconductor lasers are used for optical meters and sensors, medical purposes, and performing measurements. Accordingly, the world's leading companies have been releasing various types of wavelength tunable semiconductor lasers. External resonator-type wavelength tunable semiconductor lasers will now be described so that the structures of the conventional external resonator-type wavelength tunable semiconductor lasers can be clearly compared with the structures of external resonator-type wavelength tunable semiconductor lasers according to embodiments of the present invention.

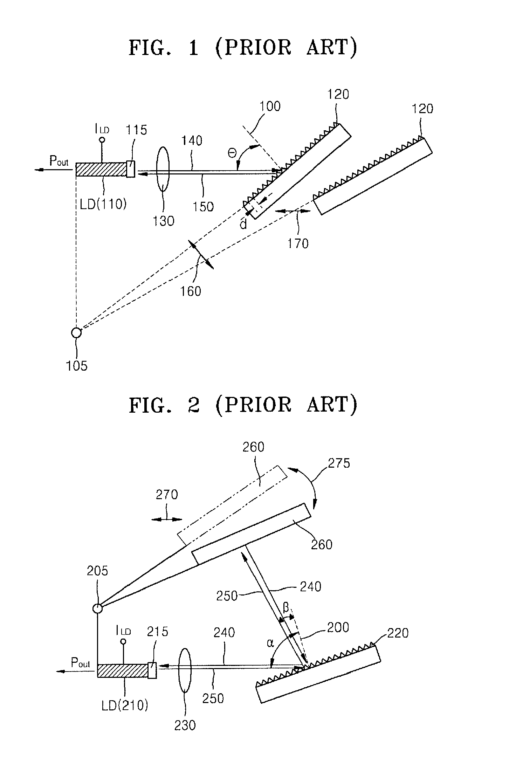

FIG. 1 is a schematic diagram of a conventional Littrow external resonator-type wavelength tunable light source. Referring to FIG. 1, the conventional Littrow external resonator-type wavelength tunable light source includes a semiconductor laser (laser diode (LD)) 110 coated with an anti-reflection film 115, an external diffraction grating 120, and a lens 130. A current $I_{LD}$ is applied to the semiconductor laser 110 to generate a beam 140. When the beam 140 generated by the semiconductor laser 110 reaches the diffraction grating 120 via the lens 130, the wavelength of a diffracted beam 150 is determined according to an incident angle θ with respect to a line 100 which is perpendicular to a surface of the diffraction grating 120 using the Littrow diffraction grating equation below. The diffracted beam 150, which has a particular wavelength, is fed back to the semiconductor laser 110, and a ray Pout is output.

$$m\lambda = 2d\sin\theta, \quad \ldots(1)$$

where m denotes a diffraction order, λ denotes the wavelength of the diffracted beam, d denotes a diffraction grating spacing, and θ denotes an incident angle.

When the diffraction grating 120 is moved with respect to a pivot point 105, which is a virtual point at which a line extending perpendicular to an end of the semiconductor laser 110 farthest from the diffraction grating 120 and a line extending parallel from the diffraction grating 120 meet, the diffraction grating 120 rotates as indicated by an arrow 160. Accordingly, the incident angle θ is changed, and the wavelength of the diffracted beam 150 is changed according to Equation 1.

When only the incident angle θ is changed, the wavelength can be tuned in a discrete manner. Therefore, the diffraction grating 120 can also be translated as indicated by an arrow 170 to obtain continuous wavelength tunability.

In other words, the conventional Littrow external resonator-type wavelength tunable light source allows continuous wavelength tunability by changing a diffraction condition through the displacement, that is, rotation and translation, of the diffraction grating 120 with respect to the pivot point 105.

Due to its high output power, narrow line width, and wide wavelength tunability, the conventional Littrow external resonator-type wavelength tunable light source of FIG. 1 is widely used in measurement equipment.

However, it is difficult to align the semiconductor laser 110 and the diffraction grating 120 included in the conventional Littrow external resonator-type wavelength tunable light source. Further, the spatial movement of the diffraction grating 120 during wavelength tuning causes mechanical oscillation, and the aging of the pivot point 105 causes a wavelength shift. In particular, since the wavelength of the light source of FIG. 1 can only be tuned very slowly, it is difficult to use the light source of FIG. 1 in optical communication and other various applications.

FIG. 2 is a schematic diagram of a conventional Littman external resonator-type wavelength tunable light source. Referring to FIG. 2, the conventional Littman external resonator-type wavelength tunable light source includes a semiconductor laser (LD) 210 coated with an anti-reflection film 215, an external diffraction grating 220, a lens 230, and a reflective mirror 260.

A current $I_{LD}$ is applied to the semiconductor laser 210 to generate a beam 250. When the beam 250 generated by the semiconductor laser 210 reaches the reflective mirror 260 via the lens 230 and the diffraction grating 220, the portion of the beam 250 perpendicularly incident on the reflective mirror 260 is reflected back to the diffraction grating 220.

A reflected beam 240 is fed back to the semiconductor laser 210 via the diffraction grating 220 and the lens 230, and a ray Pout is output. In the conventional Littman external resonator-type wavelength tunable light source of FIG. 2, the wavelength of the reflected beam 240 is determined according to an incident angle $\alpha$ and a diffraction angle $\beta$ with respect to a line 200 which is perpendicular to a surface of the diffraction grating 220 using the Littman diffraction grating equation defined below.

$$m\lambda = d(\sin\alpha + \sin\beta), \quad \ldots(2)$$

where m denotes a diffraction order, $\lambda$ denotes the wavelength of the reflected beam 240, d denotes the diffraction grating spacing, $\alpha$ denotes the incident angle, and $\beta$ denotes the diffraction angle.

In the conventional Littman external resonator-type wavelength tunable light source of FIG. 2, when the reflective mirror 260 is moved with respect to a pivot point 205, the reflective mirror 260 rotates as indicated by an arrow 275. Accordingly, the diffraction angle $\beta$ is changed while the incident angle $\alpha$ is maintained constant, and the wavelength of the reflected beam 240 is also changed according to Equation 2.

In this structure, when only the diffraction angle $\beta$ is changed, the wavelength can be tuned discretely. Therefore, the reflective mirror 260 is also translated to obtain continuous wavelength tunability.

In other words, the conventional Littman external resonator-type wavelength tunable light source allows continuous wavelength tunability by changing the diffraction condition through the displacement, that is, rotation and translation, of the reflective mirror 270 with respect to the pivot point 205.

In the light source of FIG. 2, the diffraction grating 220 is fixed while the reflective mirror 260 is moved during wavelength tuning. Therefore, the light source of FIG. 2 has a more stable structure than the light source of FIG. 1.

However, it is difficult to align the semiconductor laser 210 and the diffraction grating 220 included in the light source of FIG. 2. Further, the spatial movement of the reflective mirror 260 during wavelength tuning causes mechanical oscillation, and the aging of the pivot point 205 causes a wavelength shift. In particular, since the wavelength of the light source of FIG. 2 can only be tuned very slowly, it is difficult to use the light source of FIG. 2 in optical communication and other various applications.

To solve the problem of the slow wavelength tuning of the external resonator-type wavelength tunable light sources of FIGS. 1 and 2, structures for performing wavelength tuning through electrical adjustment have been suggested. For example, M. Kourogi and four others suggest wavelength tuning using beam deflection according to a frequency change of an external electrical signal by inserting an acousto-optic modulator (AOM) between a laser diode and a diffraction grating instead of moving the diffraction grating for wavelength tuning in "Continuous Tuning of an Electrically Tunable External-Cavity Semiconductor Laser," Optics Letters, vol. 25, No. 16, pp. 165-1167, August 15, 2000.

However, in this case, the size of the AOM and an insertion loss are large, and a wavelength tunable range is as narrow as 2 nm.

To sum up, a conventional wavelength tunable light source which performs wavelength tuning by spatially moving a diffraction grating has many problems in terms of reliability and speed. In the case of a conventional bulk-type wavelength tunable light source which performs electrical wavelength tuning, it is difficult to align a diffraction grating and a laser diode, and the size of the conventional bulk-type wavelength tunable light source is large since an AOM is inserted thereinto.

SUMMARY OF THE INVENTION

The present invention provides a wavelength tunable light source including bulk-type optical parts integrated in a single substrate without requiring additional optical parts or optical alignment.

The present invention also provides a wavelength tunable light source with a hybrid integration of a concave diffraction grating formed of a material (silicon or polymer) which has reliable reproduction characteristics, and the SOA or the laser diode formed of Indium Phosphide(InP) or Galium Arsenide(GaAs), thereby minimizing optical coupling loss between the two materials and increasing the reliability of the wavelength tunable light source.

According to an aspect of the present invention, there is provided a wavelength tunable light source comprising: a semiconductor optical amplifier (SOA) generating an optical signal having a predetermined wavelength band in a first direction and outputting the amplified optical signal having a predetermined single wavelength inside the wavelength band in a second direction opposite to the first direction; a beam steering unit altering an output path of the wavelength band optical signal; and a waveguide having a linear end connected to the beam steering unit, the wavelength band optical signal being spread from the linear end and the other end formed of a concave diffraction grating which reflects and diffracts the wavelength band optical signal and enables the single wavelength optical signal to have constructive interference at the linear end, wherein the constructively-interfered single wavelength optical signal is focused at the linear end and is fed back to the SOA via the beam steering unit.

According to another aspect of the present invention, there is provided a wavelength tunable light source comprising: a semiconductor optical amplifier (SOA) generating an optical signal having a predetermined wavelength band in a first direction and outputting the amplified optical signal having a predetermined single wavelength inside the wavelength band in a second direction opposite to the first direction; a waveguide having a linear end connected to the SOA, the wavelength band optical signal being spread from the linear end and the other end formed of a concave diffraction grating which reflects and diffracts the wavelength band optical signal and enables the single wavelength optical signal to have constructive interference at the linear end; and a deflector that is disposed on the upper cladding layer and varies the degree of deflection of the wavelength band optical signal according to a current supplied to the deflector, wherein the constructively-interfered single wavelength optical signal is focused at the linear end and is fed back to the SOA via the beam steering unit.

According to another aspect of the present invention, there is provided a wavelength tunable light source comprising: a first SOA generating an optical signal having a predetermined wavelength band in a first direction and outputting amplified first and second single wavelengths inside the wavelength band in a second direction opposite to the first direction; a beam steering unit altering an output path of the wavelength band optical signal; a waveguide having a linear end connected to the beam steering unit, the wavelength band optical signal being spread from the linear end, and the other end formed of a concave diffraction grating with satisfying a Littman diffraction grating condition which reflects and diffracts the wavelength band optical signal and enables the first single wavelength optical signal to have constructive interference at a first part of the linear end and enables the second single wavelength optical signal to have constructive interference constructive at a second part of the linear end; and second SOAs to feed back the second single wavelength optical signal to the first SOA after re-inputting the second single wavelength optical signal to the concave diffraction grating of the waveguide.

According to another aspect of the present invention, there is provided a wavelength tunable light source comprising: a first SOA generating an optical signal having a predetermined wavelength band in a first direction and outputting amplified first and second single wavelengths inside the wavelength band in a second direction opposite to the first direction; a waveguide having a linear end connected to the SOA, the wavelength band optical signal being spread from the linear end, and the other end formed of a concave diffraction grating with satisfying a Littman diffraction grating condition which reflects and diffracts the wavelength band optical signal and enables the first single wavelength optical signal to have constructive interference at a first part of the linear end and enables the second single wavelength optical signal to have constructive interference constructive at a second part of the linear end; a deflector that is disposed on the upper cladding layer and varies the degree of deflection of the wavelength band optical signal according to a current supplied to the deflector; and second SOAs to feed back the second single wavelength optical signal to the first SOA after re-inputting the second single wavelength optical signal to the concave diffraction grating of the waveguide.

## BRIEF DESCRIPTION OF THE DRAWINGS

The above and other features and advantages of the present invention will become more apparent by describing in detail exemplary embodiments thereof with reference to the attached drawings in which:

FIG. 1 is a schematic diagram of a conventional Littrow external resonator-type wavelength tunable light source;
FIG. 2 is a schematic diagram of a conventional Littman external resonator-type wavelength tunable light source;
FIG. 3 is a schematic diagram of an optical deflector-integrated wavelength tunable light source including a Roland-circle-based diffraction grating;
FIG. 4 illustrates the wavelength tunability of the wavelength tunable light source of FIG. 3;
FIG. 5 illustrates a beam steering unit-integrated wavelength tunable light source including a Roland-circle-based diffraction grating;
FIG. 6 illustrates the wavelength tunability of the wavelength tunable light source of FIG. 5;
FIG. 7 is a schematic diagram of a beam steering unit-integrated wavelength tunable light source including a concave diffraction grating which produces a straight beam track according to an embodiment of the present invention;

FIG. 8 illustrates the concave diffraction grating of FIG. 7 which makes the track of a wavelength tunable beam straight;

FIG. 9 is a schematic diagram of a wavelength tunable light source with a hybrid integration of a concave diffraction grating, which produces a straight beam track and is formed of silicon or polymer, and a semiconductor optical amplifier (SOA) and a beam steering unit, which are formed of Indium Phosphide(InP) or Galium Arsenide(GaAs), according to an embodiment of the present invention;

FIG. 10 is a schematic diagram of an optical deflector-integrated wavelength tunable light source including a concave diffraction grating which produces a straight beam track according to an embodiment of the present invention;

FIG. 11 is a schematic diagram of a beam steering unit-integrated wavelength tunable light source including a concave diffraction grating which satisfies a Littman condition defined in Equation 12 and produces a straight beam track according to an embodiment of the present invention;

FIG. 12 is a schematic diagram of a wavelength tunable light source with a hybrid integration of a concave diffraction grating, which is formed of silicon or polymer, and an SOA and a beam steering unit, which are formed of Indium Phosphide(InP) or Galium Arsenide(GaAs), according to an embodiment of the present invention;

FIG. 13 is a schematic diagram of an optical deflector-integrated wavelength tunable light source including a concave diffraction grating which satisfies the Littman condition and produces a straight wavelength tunable beam track according to an embodiment of the present invention;

FIG. 14 is a flowchart illustrating an operating principle of the wavelength tunable light source of FIG. 7; and

FIG. 15 is a flowchart illustrating an operating principle of the wavelength tunable light source of FIG. 11.

DETAILED DESCRIPTION OF THE INVENTION

The present invention will now be described more fully with reference to the accompanying drawings, in which exemplary embodiments of the invention are shown. The invention may, however, be embodied in many different forms and should not be construed as being limited to the embodiments set forth therein; rather, these embodiments are provided so that this disclosure will be thorough and complete, and will fully convey the concept of the invention to those skilled in the art.

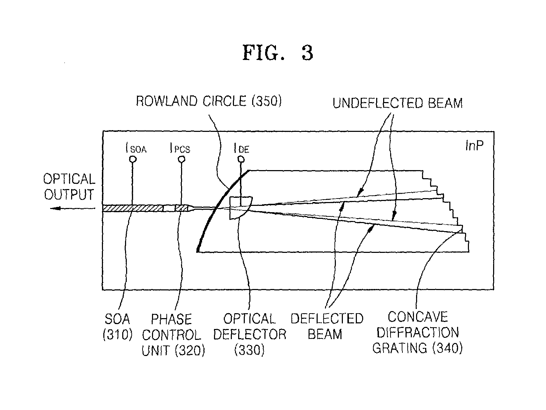

FIG. 3 is a schematic diagram of an optical deflector-integrated wavelength tunable light source including a Roland-circle-based diffraction grating. Referring to FIG. 3, the wavelength tunable light source is an external resonator-type wavelength tunable laser includes a semiconductor optical amplifier (SOA) 310, a phase control unit 320, an optical deflector 330, and a concave diffraction grating 340.

The SOA 310, the phase control unit 320, the optical deflector 330, and the concave diffraction grating 340 are integrated on a single substrate formed of Indium Phosphide(InP) or Galium Arsenide(GaAs). Since an angle at which a guided beam is incident on the concave diffraction grating 340 depends on the magnitude of current injected into the optical deflector 330, wavelength tuning can be performed by the deflection angle of the guided beam.

A beam output from one end of the SOA 310 is incident on the concave diffraction grating 340 via the phase control unit 320 and the optical deflector 330, sequentially.

The beam is then reflected at a surface of the concave diffraction grating 340 due to a difference between the refractive index of a semiconductor material that constitutes the concave diffraction grating 340 and the refractive index of air. At this time, the reflection beam is scattered to different locations according to wavelength due to diffraction characteristics of the concave diffraction grating 340. The wave of the reflected beam that is scattered to different locations according to wavelength forms a virtual circle, which is called a Rowland circle 350.

In general, when the radius of the concave diffraction grating 340 is twice the radius of the Roland circle 350, the wavelength tuning can be obtained.

In the wavelength tunable light source of FIG. 3, when the left end of a waveguide including the concave diffraction grating 340 matches the Roland circle 350, the beam having a specific single reflected wavelength is fed back to the SOA 310. The wavelength tunable light source functions as an external resonator-type laser due to resonance that occurs between the left end of the SOA 310 and the concave diffraction grating 340.

The phase control unit 320 may be inserted between the SOA 310 and the optical deflector 330. The phase control unit 320 matches the phase of a beam emitted from the SOA 310 and the phase of a beam input to the SOA 310 from the concave diffraction grating 340. In addition, the phase control unit 320 changes the refractive index of a wavelength material using incident current, thereby controlling the phase of the resonant beam.

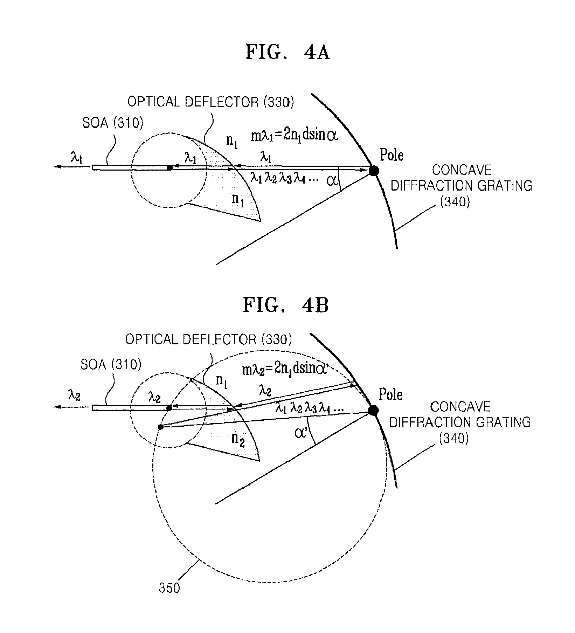

FIG. 4 illustrates the wavelength tunability of the wavelength tunable light source of FIG. 3.

Specifically, FIG. 4A illustrates beam characteristics when an electrical signal is not transmitted to the optical deflector 330. A beam to which an optical gain generated by the SOA 310 is applied passes through the optical deflector 330 with a wavelength of $\lambda_1$. Since a region in which the optical deflector 330 is disposed and its surrounding region have identical effective indices of refraction, the beam is not reflected at the optical deflector 330. Of the beam incident on the concave diffraction grating 340, a portion having a wavelength of $\lambda_1$ is fed back to the SOA 310 when the beam has an incident angle α, as indicated by

$$m\lambda = 2n_1 d\sin\alpha$$
, ...(3)

where m denotes a diffraction order, λ denotes the wavelength, $n_1$ denotes the refractive index of a waveguide layer, and d denotes a diffraction grating spacing.

Therefore, of the beam generated by the SOA 310, the portion having the wavelength of $\lambda_1$ is fed back from the concave diffraction grating 340 to the SOA 310. Resonance occurs when the intensity of the portion of the beam fed back to the SOA 310 is identical to the amount of the beam lost while travelling through the entire wavelength tunable light source, and, in this case, the wavelength tunable light source can function as a laser. Ultimately, the portion of the beam having the wavelength of $\lambda_1$ is output from the left end of the SOA 310.

When current is injected into the optical deflector 330, the refractive index of a core layer included in a semiconductor material under the optical deflector 330 is changed due to a carrier-induced reflective index variation.

Accordingly, when a beam passes through the region in which the optical deflector 330 is formed after the refractive index of the core material has been changed, the beam is refracted at a boundary between the region having the changed refractive index and a region having an unchanged refractive index according to Snell's Law.

Due to the refraction, the angle at which the refracted beam is incident on the concave diffraction grating 340 and the wavelength of the reflected beam to be fed back to the SOA 310 are varied according to Equation 3.

FIG. 4B illustrates beam characteristics when an electrical signal is transmitted to the optical deflector 330 and thus the refractive index of the waveguide layer in the optical deflector 330 is changed from a first effective refractive index $n_1$ to a second effective refractive index $n_2$.

A beam generated by the SOA 310 passes through the optical deflector 330 and is refracted according to a difference in the refractive indexes of the semiconductor material under the optical deflector 330 and that of the external region except for the optical deflector 330 region. A source point of the refracted beam coincides with the Rowland circle 350 as illustrated in FIG. 4B, and the incident angle of the refracted beam is changed from a to α'.

The changed incident angle also varies the wavelength of the diffracted beam from the concave diffraction grating 340 from $\lambda_1$ to $\lambda_2$. The region in which the optical deflector 330 is patterned may be embodied of by use of a material having the first effective refractive index $n_1$ and by current-injection within the region forming optical deflector 330. The refractive index of the waveguide layer within the region in which the optical deflector 330 is formed is changed from the first effective refractive index $n_1$ to a second effective refractive index $n_2$ by injecting current into the region in which the optical deflector 330 is formed. Additionally, the region in which the optical deflector is formed may be formed by use of a material having the second refractive index $n_2$ and by current-injection within the region forming optical deflector 330. In this case, the refractive index of the waveguide layer within the region in which the optical deflector 330 is formed is changed from the second effective refractive index $n_2$ to a third effective refractive index $n_3$. Therefore, when the refractive index of the core material included in the semiconductor material under the optical deflector 330 is changed in response to an external electrical signal (current), the beam is deflected at the patterned boundary according to Snell's Law

The optical deflector 330 may be structured such that a source point of a beam emitted from the SOA 310 moves along the Rowland circle 350 as the amount of the current injected into the optical deflector 330 increases.

The shape of the optical deflector 330 may be designed from a ray-optics perspective or a wave-point perspective to match the shape of the Rowland circle 350.

The wavelength tunable light source of FIG. 3 can perform fast and stable wavelength tuning through electrical adjustment. Since all elements are integrated on a single substrate, the size of the wavelength tunable light source is small. In addition, since the left end of the waveguide is accurately disposed on the Rowland circle 350, the coupling characteristics of a beam spread from the Rowland circle 350 to the concave diffraction grating 340 and a beam fed back from the concave diffraction grating 340 to the Rowland circle 350 are excellent, and thus high optical output can be achieved.

However, since the optical deflector 330 is disposed along a path of a beam, when current is injected into the optical deflector 330, optical loss is increased, which in turn reduces the optical output and increases variations in the optical output. Further, it is difficult to design and implement the pattern of the optical deflector 330.

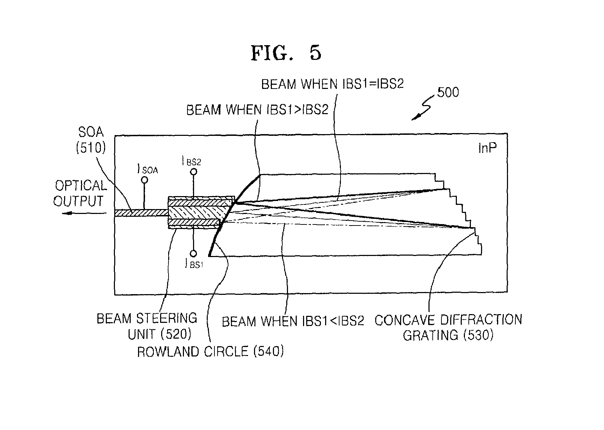

FIG. 5 illustrates a beam steering unit-integrated wavelength tunable light source 500 including a Roland-circle-based diffraction grating (concave diffraction grating) 530. Referring to FIG. 5, the wavelength tunable light source 500 includes an SOA 510, a beam steering unit 520, and the concave diffraction grating 530 integrated in a single substrate formed of Indium Phosphide(InP) or Galium Arsenide(GaAs). The angle of incidence of a guided beam on the concave diffraction grating 530 is changed by steering the guided beam according to the difference between currents injected into two electrodes in the beam steering unit 520. In this way, wavelength tuning is performed.

The refractive index of the beam steering unit 520 is changed according to currents $I_{BS1}$ and $I_{BS2}$ injected into the two electrodes included in the beam steering unit 520, and the changed refractive index affects an incident angle of a beam on the concave diffraction grating 530. In other words, the beam steering unit 520 functions as a prism.

In general, as the current supplied to the beam steering unit 520 increases, the effective refractive index of the core layer is reduced. The greater the refractive index of a waveguide, the more refracted a beam is. The beam output from he SOA 510 is bent toward one of the two electrodes of the beam steering unit 520 to which low current is applied.

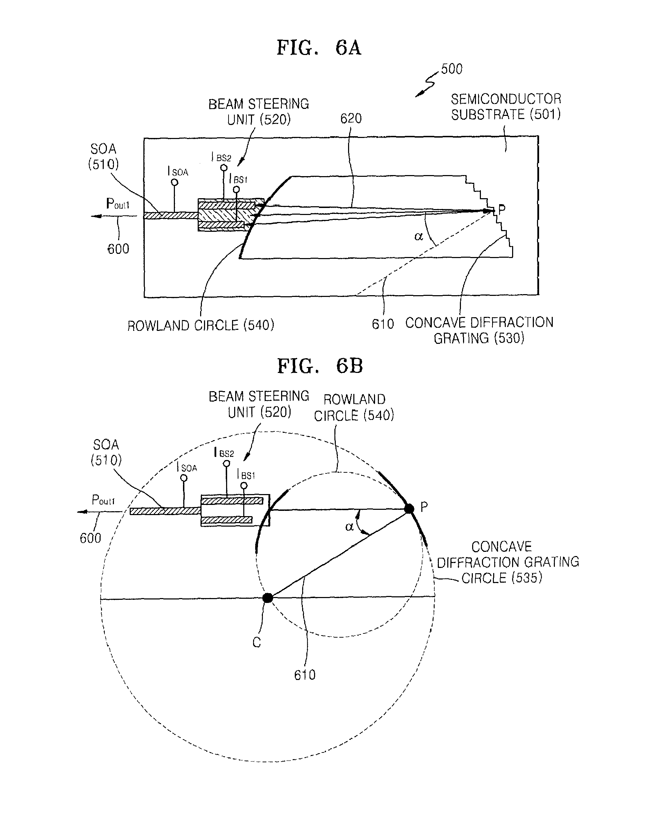

FIG. 6 illustrates the wavelength tunability of the wavelength tunable light source 500 of FIG. 5.

Specifically, the wavelength tunable light source 500 illustrated in FIGS. 6A and 6B is structured to satisfy the Littrow condition defined by Equation 3.

The wavelength tunable light source 500 illustrated in FIG. 6A includes the SOA 510, the beam steering unit 520, and the concave diffraction grating 530 integrated on a single semiconductor substrate 501 formed of, for example, Indium Phosphide(InP) or Galium Arsenide(GaAs) .

The SOA 510 may be a semiconductor laser diode, and a current $I_{SOA}$ may be supplied to the SOA 510.

The beam steering unit 520 includes two electrodes, and electrical signals, for example, the currents $I_{BS1}$ and $I_{BS2}$, may be transmitted to the two electrodes.

The concave diffraction grating 530 is disposed in a side region of the semiconductor substrate 501. The structure of the concave diffraction grating 530 is not limited to a particular structure. However, the concave diffraction grating 530 structured as a Rowland circle 540 is presented for the current description. A concave diffraction grating circle 535 based on the Rowland circle 540 is illustrated in FIG. 6B.

The concave diffraction grating circle 535 and the Rowland circle 540 meet at a point P, and a base line 610 extends from a center C of the concave diffraction grating circle 535 to the point P. A side of the Rowland circle 540 contacts the beam steering unit 520.

Referring to FIG. 6A, since the left end of the SOA 510 and the concave diffraction grating 530 are reflective surfaces, they operate as a resonator. Therefore, the wavelength tunable light source 500 can operate as a laser diode.

A beam 620 emitted from the SOA 510 toward the concave diffraction grating 530 passes through the beam steering unit 520 and is incident on the concave diffraction grating 530 at the point P. Of the beam 620 incident on the concave diffraction grating 530, a particular single wavelength optical signal is fed back to the SOA at an angle equal to an incident angle $\alpha$ according to the diffraction characteristics of the concave diffraction grating 530. Consequently, a beam 600 having the particular wavelength is output as indicated by an arrow Pout1. The wavelength of the output beam 600 is determined by the Littrow diffraction grating equation (Equation 3).

The incident angle $\alpha$ indicates an angle formed by the base line 610 and the path of the incident beam 620 as illustrated in FIGS. 6A and 6B.

The beam steering unit 520 includes two electrodes and steers a beam by adjusting the difference between the currents $I_{BS1}$ and $I_{BS2}$ supplied to the two electrodes. Accordingly, the incident angle $\alpha$ of the beam 620 whose path can been changed.

The wavelength of the diffracted beam 620 is changed according to Equation 3 based on the change in the incident angle $\alpha$ of the beam 620.

The beam steering unit-integrated wavelength tunable light source 500 can perform fast and stable wavelength tuning through electrical adjustment. Since all elements are integrated in a single substrate, the size of the wavelength tunable light source is small. In addition, since current is injected into a region around the beam path, optical loss due to wavelength tuning is small and optical output is hardly varied.

However, the location at which the beam 620 is steered is on the Rowland circle 540, and the width of the beam steering unit 520 is large. Therefore, the two electrodes included in the beam steering unit 520 are asymmetrical with respect to each other, which distorts the shape of the beam 620 steered by the beam steering unit 520 and makes it impossible to place the beam 620 precisely on the Rowland circle 540. Consequently, the coupling characteristics of a beam spread from the Rowland circle 540 to the concave diffraction grating 530 and a beam fed back from the concave diffraction grating 530 to the Rowland circle 540 are low, which results in low optical output.

To sum up, although the optical deflector-integrated wavelength tunable light source including the Roland-circle-based diffraction grating described with reference to FIGS. 3 and 4 has high optical output, since the optical deflector 330 is placed on the beam path, optical loss is increased during wavelength tuning, which results in variations in the optical output. The beam steering unit-integrated wavelength tunable light source 500 including the Roland-circle-based diffraction grating 530 described with reference to FIGS. 5 and 6 has an optical output with low variation since the two electrodes included in the beam steering unit 520 are disposed near the beam path. However, since the two electrodes are asymmetrical with respect to each other, the coupling efficiency is reduced and the optical output is low.

In addition, all elements of the optical deflector-integrated wavelength tunable light sources including the Roland-circle-based diffraction grating are integrated in a single substrate formed of Indium Phosphide(InP) or Galium Arsenide (GaAs).

However, when the concave diffraction grating 340 is formed of Indium Phosphide(InP) or Galium Arsenide (GaAs), the concave diffraction grating 340 cannot be precisely patterned due to uneven etching characteristics of the Indium Phosphide(InP) or Galium Arsenide(GaAs).

Therefore, a hybrid integration of the concave diffraction grating 340 formed of silicon or polymer, which has uniform etching characteristics and can be precisely patterned, and the SOA 310 formed of the Indium Phosphide(InP) or Galium Arsenide(GaAs) may be desirable.

However, since the boundary surface between the concave diffraction grating 340 and the SOA 310 is on the Rowland circle 350, the hybrid integration is substantially difficult.

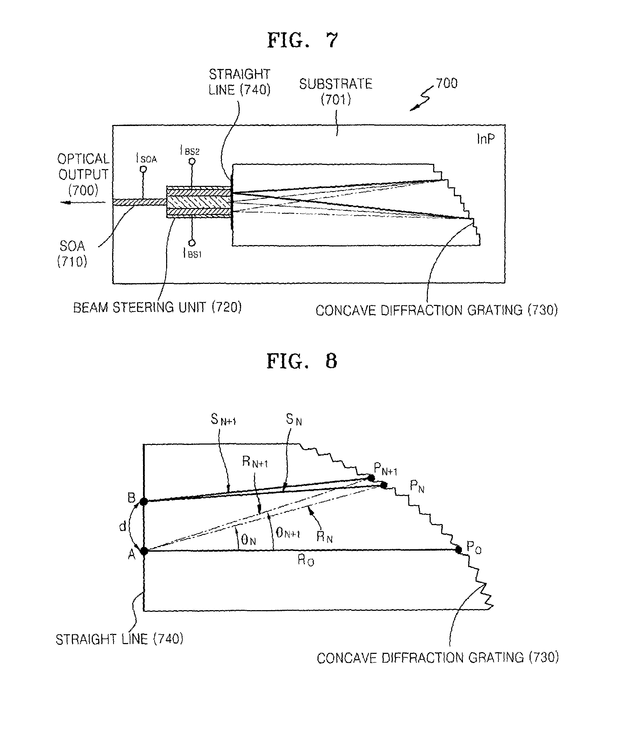

FIG. 7 is a schematic diagram of a beam steering unit-integrated wavelength tunable light source 700 including a concave diffraction grating 730 which provides a straight beam track according to an embodiment of the present invention. Referring to FIG. 7, the wavelength tunable light source 700 includes an SOA 710, a beam steering unit 720, and the concave diffraction grating 730 integrated on a single substrate formed of Indium Phosphide(InP) or Galium Arsenide(GaAs).

The SOA 710 may be a semiconductor laser diode, and a current $I_{SOA}$ may be supplied to the SOA 710.

The beam steering unit 720 includes two electrodes, and currents $I_{BS1}$ and $I_{BS2}$ may be transmitted to the two electrodes.

The concave diffraction grating 730 is disposed in a side region of the semiconductor substrate 701. The structure of the concave diffraction grating 730 can be similar to the concave diffraction grating 530 illustrated in FIG. 5. However, the structure of the concave diffraction grating 730 is not limited to a particular structure. That is, the concave diffraction grating 730 according to the present embodiment is not a Rowland circle-based diffraction grating. Instead, the concave diffraction grating 730 is structured such that the track of points to which a beam is diffracted by the concave diffraction grating 730 is straight.

Since the positions to which the beam is diffracted form a straight line, the two electrodes included in the beam steering unit 720 are formed symmetrical to each other, and positions to which the beam is diffracted are moved along the straight line according to the difference between the currents supplied to the two electrodes.

FIG. 8 illustrates the concave diffraction grating 730 of FIG. 7 which makes the track of a wavelength tunable beam straight.

The structure variables illustrated in FIG. 8 other than $\theta_N$ and $\theta_{N+1}$ are defined as

$$\overline{AB} = d \qquad \overline{AP_0} = R_0$$
$$\overline{BP_N} = S_N \qquad \overline{AP_N} = R_N$$
$$\overline{BP_{N+1}} = S_{N+1} \qquad \overline{AP_{N+1}} = R_{N+1} , \qquad \ldots(4)$$

Light with a particular wavelength $\lambda_0$ that is diffracted between a point $P_N$ and a point $P_{N+1}$ of the concave diffraction grating 730 constructively interferes at a point A is defined by

$$\frac{4\pi n_{eff}}{\lambda_0}(R_N - R_{N+1}) = 2\pi m , \qquad \ldots(5)$$

where $n_{eff}$ denotes an effective refractive index of a waveguide, and m is an integer. Equation 5 defines the relationship between $R_{N+1}$ and $R_N$ and can be rewritten as

$$R_{N+1} = R_N - \frac{m\lambda_0}{2n_{eff}} , \quad \ldots(6)$$

The length of a line $S_N$ between the point $P_N$ and a point B, the line forming a side of a triangle formed by the points A, B and $P_N$, may be defined by Equation 7 based on the second law of cosines.

$$S_N = \sqrt{R^2 + d^2 - 2dR_N \sin\theta_N}$$
$$= R_N \sqrt{1 + \left(\frac{d}{R_N}\right)^2 - \frac{2d\sin\theta_N}{R_N}}$$
$$\approx R_N - d\sin\theta_N , \quad \ldots(7)$$

Equation 7 defines the relationship between $S_N$ and $(R_N, \theta_N)$. The second term in the root in the second line of Equation 7 can be ignored since it is very small relative to the other terms in the root. The third line of Equation 7 is a binominal approximation obtained by Taylor-expanding the root.

Similarly, light with a wavelength $\lambda_0 + \Delta\lambda$ ($\Delta\lambda$ : variation in wavelength) constructively interferes at the point A, and the relationship between $S_{N+1}$ and $S_N$ is given by Equation 8).

$$S_{N+1} = S_N - \frac{m(\lambda_0 + \Delta\lambda)}{2n_{eff}}$$
$$\approx R_N - d\sin\theta_N - \frac{m(\lambda_0 + \Delta\lambda)}{2n_{eff}} , \quad \ldots(8)$$

Here, the second line is obtained using Equation 7, thus providing the relationship between $S_{N+1}$ and $(R_N, \theta_N)$).

In a similar manner to Equation 7, the length of a line of a triangle formed by the points A, $R_{N+1}$ and B may be defined by

$$S_{N+1} = \sqrt{R_{N+1}^2 + d^2 - 2dR_{N+1}\sin\theta_{N+1}}$$
$$= R_{N+1}\sqrt{1 + \left(\frac{d}{R_{N+1}}\right)^2 - \frac{2d\sin\theta_{N+1}}{R_{N+1}}}$$
$$\approx R_{N+1} - d\sin\theta_{N+1}$$
$$\approx R_N - \frac{m\lambda_0}{2n_{eff}} - d\sin\theta_{N+1} , \quad \ldots(9)$$

Equation 9 indicates the relationship between $S_{N+1}$ and $(R_{N+1}, \theta_{N+1})$. By using Equation 6, the relationship between $S_{N+1}$ and $(R_N, \theta_{N+1})$ can be obtained. The third line of Equation 9 is obtained using the binominal approximation of Equation 7 and the fourth line of Equation 9 is obtained using Equation 6.

To sum up, there are four equations, that is, Equations 6 through 9, for calculating the structure variables $R_N$, $R_{N+1}$, $S_N$, $S_{N+1}$, $\theta_N$ and $\theta_{N+1}$, where $n_{eff}$ is a value determined after the shape of the waveguide is determined, and d, $R_0$, $\theta_0$ (= 0, m, $\lambda_0$, $\Delta\lambda$) are design variables (known values).

Accordingly, when $R_N$, and $\theta_N$ are known, $R_{N+1}$, $S_N$, $S_{N+1}$, and $\theta_{N+1}$ can be obtained using Equations 6 through 9, and this can be performed for all values of N through reiteration.

The variation in wavelength can be defined by a first line of Equation 10 based on the second line of Equation 8 and the fourth line of Equation 9.

$$\frac{m\Delta\lambda}{2n_{eff}d} = \sin\theta_{N+1} - \sin\theta_N$$

$$\approx \theta_{N+1} - \theta_N = g/R_N \quad , \qquad \ldots(10)$$

where $\sin\theta_N$ and $\sin\theta_{N+1}$ can be respectively approximated by $\theta_N$ and $\theta_{N+1}$ since the angles are relatively small (maximum 15 degrees), and g denotes a diffraction grating spacing (a design variable equal to the distance between $P_N$ and $P_{N+1}$). The relationship between the variation in the wavelength $\Delta\lambda$ and the design variable may be defined by

$$\Delta\lambda = \frac{2n_{eff}d}{m}\frac{g}{R_N} \quad , \qquad \ldots(11)$$

It can be easily understood from Equation 11 that the variation in the wavelength linearly increases according to structure variables as the diffraction grating d increases.

Equations 6 through 11 described above have been presented to easily describe the present invention. However, since approximations are not used when the present invention is actually designed, more complicated equations may be required.

In addition, although the relationship between a design variable d of the wavelength tunable light source and the variation in the wavelength $\Delta\lambda$ is not linear in the above description, the diffraction grating spacing g may be artificially changed to make the relationship between d and the variation in the wavelength $\Delta\lambda$ linear.

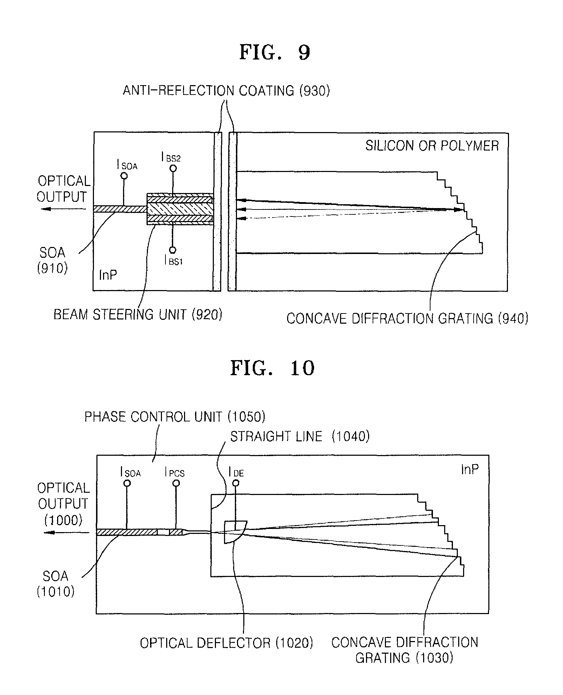

FIG. 9 is a schematic diagram of a wavelength tunable light source with a hybrid integration of a concave diffraction grating 940, which provides a straight beam track and is formed of silicon or polymer, and an SOA 910 and a beam steering unit 920, which are formed of Indium Phosphide(InP) or Galium Arsenide(GaAs), according to an embodiment of the present invention.

When the concave diffraction grating 940 is formed of Indium Phosphide(InP) or Galium Arsenide(GaAs), the concave diffraction grating 940 cannot be precisely patterned due to uneven etching characteristics of the Indium Phosphide(InP) or Galium Arsenide(GaAs), which results in high optical loss.

Therefore, the concave diffraction grating 940 formed of silicon or polymer, which has even etching characteristics and can be precisely patterned, and the SOA 910 formed of Indium Phosphide(InP) or Galium Arsenide(GaAs) may be integrated in a hybrid manner.

In the wavelength tunable light source of FIG. 3 or 5, the left end of the waveguide is on the Rowland circle 350 or 540. Therefore, the hybrid integration is virtually impossible. However, in the wavelength tunable light source according to an embodiment of the present invention, since the track of a beam diffracted by the concave diffraction grating 730 forms a straight line, the hybrid integration is possible.

In addition, Indium Phosphide(InP) or Galium Arsenide(GaAs) can be easily and evenly scribed along a line perpendicular to an optical output direction, and the reflection of the optical output is approximately thirty percent.

Hence, anti-reflection coating 930 is required for a cross section of the Indium Phosphide(InP) or Galium Arsenide(GaAs). In an embodiment of the present invention, the anti-reflection coating 930 may be formed on the concave diffraction grating 940. Impedance matching oil may also be added to obtain better optical coupling characteristics.

FIG. 10 is a schematic diagram of an optical deflector-integrated wavelength tunable light source including a concave diffraction grating 1030 which provides a straight beam track according to an embodiment of the present invention. Like the wavelength tunable light source of FIG. 3, the wavelength tunable light source of FIG. 10 may include an optical deflector 1020 integrated therein.

Generally, Rowland circle-based diffraction gratings have aberrations. Such aberrations are removed by adjusting diffraction grating spacing.

However, such a method of removing an aberration by adjusting the diffraction grating spacing complicates the structure of the diffraction grating when designed. In addition, fifth order aberration cannot be removed, and it is not easy to design and manufacture the circular pattern.

However, when the diffraction grating 730, 940 or 1030 which provides a straight beam track according to an embodiment of the present invention is used, the diffraction grating spacing can be adjusted when the diffraction grating 730, 940 or 1030 is designed. Further, aberrations can be completely removed, and it is relatively easy to design and manufacture the linear pattern of the diffraction grating 730, 940 or 1030.

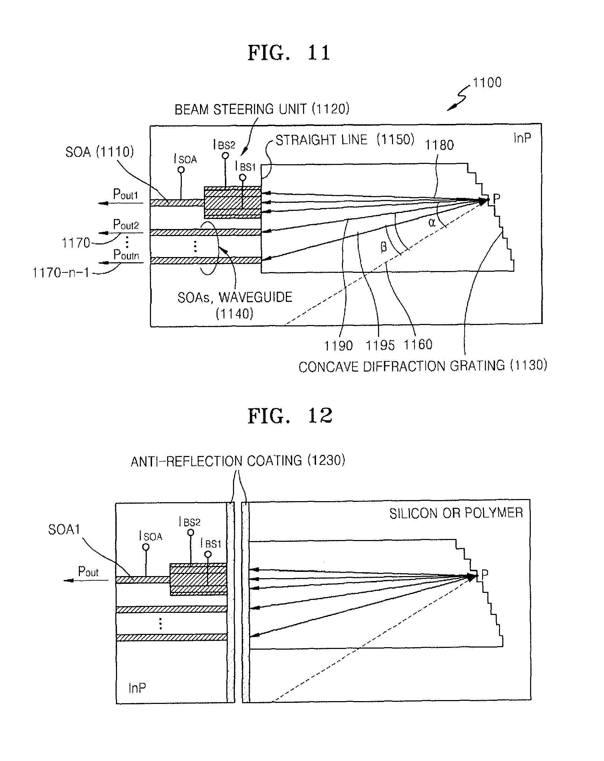

FIG. 11 is a schematic diagram of a beam steering unit-integrated wavelength tunable light source 1100 including a concave diffraction grating 1130 which satisfies the Littman condition defined by Equation 12 and provides a straight beam track according to an embodiment of the present invention.

The wavelength tunable light source 1100 (wavelength tunable laser) of FIG. 11 is structured to satisfy the Littman condition defined by Equation 12.

An angle at which a beam is incident on the concave diffraction grating 1130 is changed as the position at which the beam is incident on the concave diffraction grating 1130 varies when current is injected into the beam steering unit 1120. In this way, wavelength tuning is performed.

$$m\lambda = n_1 d(\sin\alpha + \sin\beta) \qquad \ldots(12)$$

where m denotes a diffraction order, $\lambda$ denotes the wavelength of the beam, n1 denotes the refractive index of a waveguide layer, d denotes a diffraction grating spacing, $\alpha$ denotes an incident angle, and $\beta$ denotes a diffraction angle. The incident angle $\alpha$ indicates an angle formed by a base line 1160, which extends from the center of a concave diffraction grating circle to a point P, and the path of an incident beam 1180. The diffraction angle $\beta$ is an angle formed by the base line 1160 and a beam 1190 reflected toward second SOAs or optical waveguides 1140.

The wavelength tunable light source 1100 of FIG. 11 includes the concave diffraction grating 1130 structured such that wavelength tunable beams are collected along a straight line 1150.

In FIG. 11, while the diffraction angle $\beta$ is fixed, the incident angle $\alpha$ is changed as the path of the beam 1180 moves when current is injected into the beam steering unit. In this way, wavelength tuning is performed.

The beam 1180 emitted from a first SOA 1110 passes through the beam steering unit 1120 and is incident on the concave diffraction grating 1130. Of the beam 1120 incident on the concave diffraction grating 1130, portions 1190 having particular wavelengths are fed back to the second SOAs or optical waveguides 1140 at different diffraction angles $\beta$ according to the diffraction characteristics of the concave diffraction grating 1130. Consequently, beams 1170,...,1170-n-1 having particular wavelengths are output as indicated by arrows Pout2,...,Poutn.

The wavelength tunable light source 1100 functions as a laser diode due to resonance that occurs since the left end of the first SOA 1110 and the left ends of the second SOAs 1140 are reflective surfaces.

Although the wavelength tunable light source 1100 additionally includes the optical waveguides or second SOAs 1140 for guiding or amplifying the beam 1190 diffracted by the concave diffraction grating 1130 at the diffraction angle $\beta$, the wavelength tunable light source 1100 operates more stably and has more possible designs than the wavelength tunable light source 700 of FIG. 7. For example, while the wavelength tunable light source 700 of FIG. 7 includes one optical output terminal, the wavelength tunable light source 1100 of FIG. 11 includes two or more optical output terminals since optical outputs can be obtained from the left end of the first SOA 1110 and the optical waveguides or the second SOAs 1140.

The waveguides or second SOAs 1140 included in the wavelength tunable light source 1100 resonate light and output a beam having a number of wavelengths equal to the number of second SOAs or waveguides 1140. The wavelengths of the beams in the optical waveguides or second SOAs 1140 are changed by controlling the amount of current injected into the beam steering unit 1120.

When a wavelength spacing between the optical output from beam optical waveguides or second SOAs 1140 are equal, the entire variation of wavelength is obtained after the variable amount of second SOAs 1140 when current is injected into the beam steering unit 1120 is multiplied by the number of channels. Therefore, the variable amount of wavelength can be increased by the number of optical wavelengths or second SOAs 1140.

FIG. 12 is a schematic diagram of a wavelength tunable light source with a hybrid integration of a concave diffraction grating, which is formed of silicon or polymer, and an SOA and a beam steering unit, which are formed of Indium Phosphide(InP) or Galium Arsenide(GaAs), according to an embodiment of the present invention.

When the concave diffraction grating is formed of Indium Phosphide(InP) or Galium Arsenide(GaAs), the concave diffraction grating cannot be precisely patterned due to uneven etching characteristics of the Indium Phosphide (InP) or Galium Arsenide(GaAs), which results in high optical loss.

Therefore, the concave diffraction grating formed of silicon or polymer, which has even etching characteristics and can be precisely patterned, and the SOA formed of the Indium Phosphide(InP) or Galium Arsenide(GaAs) may be integrated in a hybrid manner.

In addition, Indium Phosphide(InP) or Galium Arsenide(GaAs) can be easily and evenly scribed along a line perpendicular to an optical output direction, and the reflection of the optical output is approximately thirty percent.

Hence, anti-reflection coating 1230 is required for a cross section of the Indium Phosphide(InP) or Galium Arsenide(GaAs). In an embodiment of the present invention, the anti-reflection coating 1230 may be formed on the concave diffraction grating. Impedance matching oil may also be added to obtain better optical coupling characteristics.

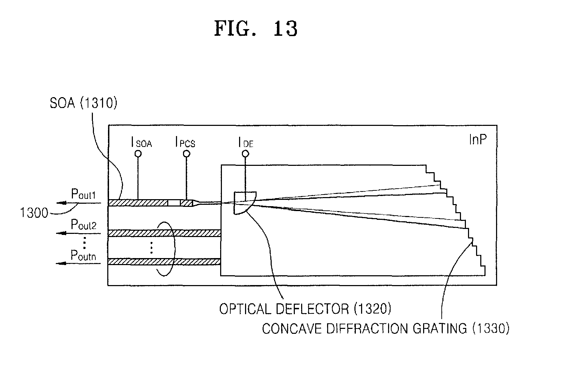

FIG. 13 is a schematic diagram of an optical deflector-integrated wavelength tunable light source including a concave diffraction grating 1330 which satisfies the Littman condition and provides a straight beam track according to an embodiment of the present invention.

The wavelength tunable light source of FIG. 13 is identical to the wavelength tunable light source 1100 of FIG. 11 except that the wavelength tunable light source of FIG. 13 deflects a beam using an optical deflector 1320 instead of a beam steering unit.

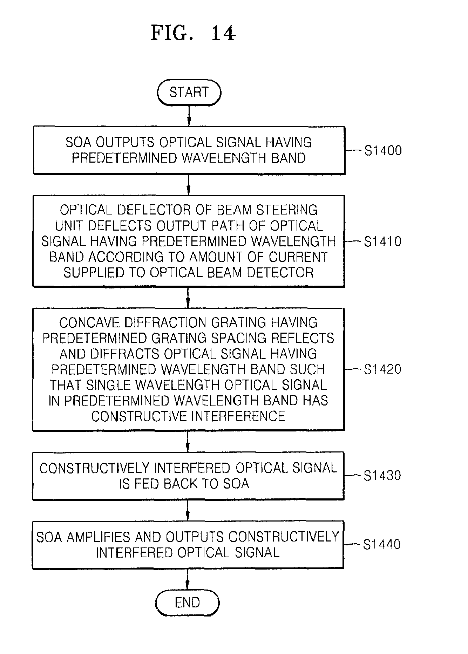

FIG. 14 is a flowchart illustrating an operating principle of the wavelength tunable light source 700 of FIG. 7. Referring to FIG. 14, an optical signal having a predetermined wavelength band is output from the SOA 710 (operation S1400).

An optical deflector of the beam steering unit 720 deflects an output path of the optical signal having the predetermined wavelength band according to the amount of current supplied to the optical deflector (operation S1410).

The concave diffraction grating 730 having a predetermined grating spacing reflects and diffracts the optical signal having the predetermined wavelength band such that a single wavelength optical signal in the predetermined wavelength band has constructive interference (operation S1420).

The constructively-interfered optical signal is fed back to the SOA 710 (operation S1430). The optical signal fed back to the SOA 710 is amplified and then output (operation S1440). Lasing occurs when a gain of the amplified optical signal is identical to optical loss within the SOA 710.

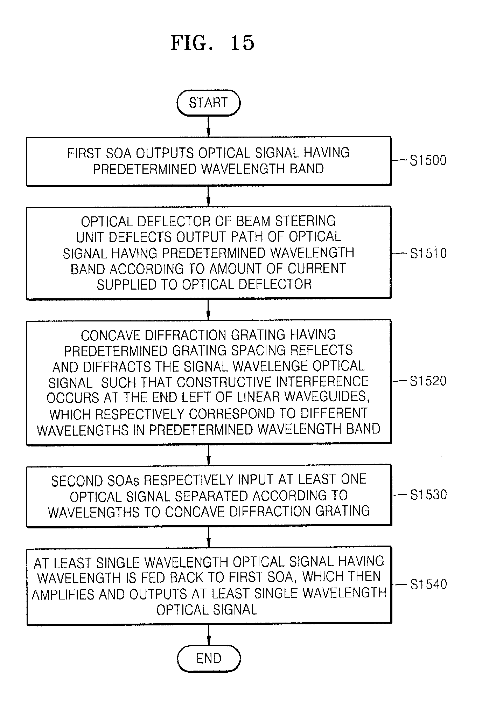

FIG. 15 is a flowchart illustrating an operating principle of the wavelength tunable light source 1100 of FIG. 11. Referring to FIG. 15, an optical signal having a predetermined wavelength band is output from the first SOA 1110 (operation S1500).

An optical deflector of the beam steering unit 1120 deflects an output path of the optical signal having the predetermined wavelength band according to the amount of current supplied to the optical deflector (operation S1510).

The concave diffraction grating 1130 having a predetermined grating spacing reflects and diffracts the optical signal having the predetermined wavelength band such that constructive interference occurs at ends of the linear waveguides, which respectively correspond to different wavelengths in the predetermined wavelength band (operation S1520).

The second SOAs 1140 respectively input at least one optical signal separated according to wavelength to the concave diffraction grating 1130 (operation S1530). The concave diffraction grating 1130 feeds the at least one the optical signal to the first SOA 1110, which then amplifies the at least one optical signal and outputs the amplified optical signal (operation S1540).

As described above, a wavelength tunable light source according to the present invention includes an SOA, a beam steering unit, and a concave diffraction grating integrated therein. The concave diffraction grating diffracts a beam to points on a straight line. Two electrodes included in the beam steering unit are symmetrical to each other, and thus prevent beam distortion. In addition, since the two electrodes enable a beam to be accurately placed on the straight track, the coupling characteristics of a beam spread to the concave diffraction grating and a beam fed back from the concave diffraction grating to a cross section of the SOA are excellent, and thus high optical output can be achieved.

Moreover, the concave diffraction grating can be formed of a material other than Indium Phosphide(InP) or Galium Arsenide(GaAs). In other words, the concave diffraction grating can be formed of a material (silicon or polymer) which has reliable reproduction characteristics, and then integrated with the SOA or the laser diode formed of the Indium Phosphide(InP) or Galium Arsenide(GaAs) in a hybrid manner. Consequently, optical coupling loss between the two materials can be minimized, and the reliability of the wavelength tunable light source can be increased.

While the present invention has been particularly shown and described with reference to exemplary embodiments thereof, it will be understood by those of ordinary skill in the art that various changes in form and details may be made therein without departing from the spirit and scope of the present invention as defined by the following claims.

**Claims**

1. A wavelength tunable light source comprising:

   a semiconductor optical amplifier (SOA) generating a optical signal having a predetermined wavelength band in a first direction and outputting the amplified optical signal having a predetermined single wavelength inside the wavelength band in a second direction opposite to the first direction;
   a beam steering unit altering an output path of the wavelength band optical signal; and
   a waveguide having a linear end connected to the beam steering unit, the wavelength band optical signal being spread from the linear end and the other end formed of a concave diffraction grating which reflects and diffracts the wavelength band optical signal and enables the single wavelength optical signal to have constructive interference at the linear end,

   wherein the constructively-interfered single wavelength optical signal is focused at the linear end and is fed back to the SOA via the beam steering unit.

2. The light source of claim 1, wherein the beam steering unit has a waveguide structure comprising:

   a lower cladding layer;
   a core layer on the lower cladding layer;
   an upper cladding layer on the core layer; and
   two electrode plates separated a predetermined distance away from each other on the upper cladding layer,

   and the degree of deflection of the optical signal having the predetermined wavelength band varies according to a current supplied to the two electrode plates.

3. The light source of claim 1 or 2, wherein the SOA, the beam steering unit, and the waveguide are integrated on a single substrate.

4. The light source of claim 1 or 2, wherein the SOA and the beam steering P: unit are integrated in a first substrate formed of III-V compound semiconductors (InP: Indium Phosphide or GaAs: Galium Arsenide), and the waveguide is integrated in a second substrate formed of silicon or polymer.

5. A wavelength tunable light source comprising:

   a semiconductor optical amplifier (SOA) generating an optical signal having a predetermined wavelength band in a first direction and outputting the amplified optical signal having a predetermined single wavelength inside the wavelength band in a second direction opposite to the first direction;
   a waveguide having a linear end connected to the SOA, the wavelength band optical signal being spread from the linear end and the other end formed of a concave diffraction grating which reflects and diffracts the wavelength band optical signal and enables the single wavelength optical signal to have constructive interference at the linear end; and
   a deflector that is disposed on the upper cladding layer and varies the degree of deflection of the wavelength band optical signal according to a current supplied to the deflector,

   wherein the constructively-interfered single wavelength optical signal is focused at the linear end and is fed back to the SOA via the beam steering unit.

6. The light source of claim 5, further comprising a phase control unit disposed between the SOA and the waveguide to match the phase of the single wavelength optical signal fed back from the concave diffraction grating to the SOA and the phase of the wavelength band optical signal output from the SOA.

7. The light source of claim 5 or 6, wherein the SOA and the waveguide are integrated in a single substrate.

8. The light source of claim 5 or 6, wherein the SOA is integrated in a first substrate formed of III-V compound semiconductors (InP: Indium Phosphide or GaAs: Galium Arsenide), and the waveguide is integrated in a second substrate formed of silicon or polymer.

9. The light source of one of claims 1 to 8, wherein the concave diffraction grating satisfies the Littrow diffraction grating condition.

10. The light source of one of claims 1 to 8, wherein the concave diffraction grating satisfies the Littman diffraction grating condition.

11. The light source of one of claims 1 to 8, wherein the concave diffraction grating satisfies the Littman diffraction grating condition, and the light source further comprises a plurality of single-mode waveguides outputting a plurality of single wavelength optical signals with different wavelengths respectively reflected and diffracted by the concave diffraction grating.

12. A wavelength tunable light source comprising:

a first SOA generating an optical signal having a predetermined wavelength band in a first direction and outputting amplified first and second single wavelengths inside the wavelength band in a second direction opposite to the first direction;
a beam steering unit altering an output path of the wavelength band optical signal;
a waveguide having a linear end connected to the beam steering unit, the wavelength band optical signal being spread from the linear end, and the other end formed of a concave diffraction grating with satisfying a Littman diffraction grating condition which reflects and diffracts the wavelength band optical signal and enables the first single wavelength optical signal to have constructive interference at a first part of the linear end and enables the second single wavelength optical signal to have constructive interference constructive at a second part of the linear end ; and
second SOAs to feed back the second single wavelength optical signal to the first SOA after re-inputting the second single wavelength optical signal to the concave diffraction grating of the waveguide.

13. The light source of claim 12, wherein the first and second SOAs and the beam steering unit are integrated in a first substrate formed of III-V compound semiconductors (InP: Indium Phosphide or GaAs: Galium Arsenide), and the waveguide is integrated in a second substrate formed of silicon or polymer.

14. A wavelength tunable light source comprising:

a first SOA generating an optical signal having a predetermined wavelength band in a first direction and outputting amplified first and second single wavelengths inside the wavelength band in a second direction opposite to the first direction;
a waveguide having a linear end connected to the SOA, the wavelength band optical signal being spread from the linear end, and the other end formed of a concave diffraction grating with satisfying a Littman diffraction grating condition which reflects and diffracts the wavelength band optical signal and enables the first single wavelength optical signal to have constructive interference at a first part of the linear end and enables the second single wavelength optical signal to have constructive interference constructive at a second part of the linear end ;
a deflector that is disposed on the upper cladding layer and varies the degree of deflection of the wavelength band optical signal according to a current supplied to the deflector; and
second SOAs to feed back the second single wavelength optical signal to the first SOA after re-inputting the second single wavelength optical signal to the concave diffraction grating of the waveguide.

15. The light source of claim 14, wherein the first and second SOAs are integrated in a first substrate formed of Ill-V compound semiconductors (InP: Indium Phosphide or GaAs: Galium Arsenide), and the waveguide is integrated in a second substrate formed of silicon or polymer.

## FIG. 1 (PRIOR ART)

## FIG. 2 (PRIOR ART)

FIG. 3

ROWLAND CIRCLE (350)    UNDEFLECTED BEAM

I SOA   I PCS    I DE    InP

OPTICAL
OUTPUT

SOA      PHASE     OPTICAL    DEFLECTED    CONCAVE
(310)   CONTROL   DEFLECTOR     BEAM      DIFFRACTION
        UNIT (320)   (330)                GRATING (340)

## FIG. 4A

OPTICAL DEFLECTOR (330)

SOA (310)

$n_1$   $m\lambda_1 = 2n_1 d \sin\alpha$

$\lambda_1$

$\lambda_1$   $\lambda_1$   $\lambda_1$

$\lambda_1 \lambda_2 \lambda_3 \lambda_4 \dots$   $\alpha$

$n_1$

Pole

CONCAVE
DIFFRACTION GRATING
(340)

## FIG. 4B

OPTICAL DEFLECTOR (330)

SOA (310)

$n_1$   $m\lambda_2 = 2n_1 d \sin\alpha'$

$\lambda_2$

$\lambda_2$   $\lambda_2$

$\lambda_1 \lambda_2 \lambda_3 \lambda_4 \dots$

$n_2$   $\alpha'$

Pole

CONCAVE
DIFFRACTION GRATING
(340)

350

FIG. 5

BEAM WHEN IBS1=IBS2

BEAM WHEN IBS1>IBS2

500

SOA
(510)

InP

I SOA

I BS2

OPTICAL
OUTPUT

I BS1

BEAM STEERING
UNIT (520)

BEAM WHEN IBS1<IBS2   CONCAVE DIFFRACTION
GRATING (530)

ROWLAND CIRCLE (540)

## FIG. 6A

## FIG. 6B

EP 1 796 231 A2

# FIG. 7

STRAIGHT LINE (740)
SUBSTRATE (701)
700
InP
OPTICAL OUTPUT (700)
I SOA
I BS2
I BS1
SOA (710)
BEAM STEERING UNIT (720)
CONCAVE DIFFRACTION GRATING (730)

# FIG. 8

$S_{N+1}$
$S_N$
$R_{N+1}$
$P_{N+1}$
$P_N$
B
d
$\theta_N$
$\theta_{N+1}$
$R_N$
A
$R_0$
$P_0$
STRAIGHT LINE (740)
CONCAVE DIFFRACTION GRATING (730)

20

## FIG. 9

ANTI-REFLECTION COATING (930)

SILICON OR POLYMER

OPTICAL
OUTPUT

$I_{SOA}$  $I_{BS2}$

$I_{BS1}$

SOA
(910)

InP

BEAM STEERING UNIT (920)

CONCAVE DIFFRACTION GRATING (940)

## FIG. 10

PHASE CONTROL UNIT (1050)

STRAIGHT LINE (1040)

InP

OPTICAL
OUTPUT
(1000)

$I_{SOA}$  $I_{PCS}$  $I_{DE}$

SOA
(1010)

OPTICAL DEFLECTOR (1020)

CONCAVE DIFFRACTION
GRATING (1030)

EP 1 796 231 A2

FIG. 11

1100

BEAM STEERING UNIT (1120)

SOA (1110)

$I_{BS2}$

$I_{SOA}$

$I_{BS1}$

STRAIGHT LINE (1150)  1180

InP

$P_{out1}$

$P_{out2}$

1170

$P_{outn}$

1170-n-1

α

β

P

SOAs, WAVEGUIDE (1140)

1190  1195  1160

CONCAVE DIFFRACTION GRATING (1130)

FIG. 12

ANTI-REFLECTION COATING (1230)

SOA1

$I_{SOA}$

$I_{BS2}$

$I_{BS1}$

SILICON OR POLYMER

$P_{out}$

P

InP

22

FIG. 13

SOA (1310)

InP

I SOA   I PCS   I DE

P out1

1300

P out2

P outn

OPTICAL DEFLECTOR (1320)

CONCAVE DIFFRACTION GRATING (1330)

# FIG. 14

START

SOA OUTPUTS OPTICAL SIGNAL HAVING
PREDETERMINED WAVELENGTH BAND — S1400

OPTICAL DEFLECTOR OF BEAM STEERING
UNIT DEFLECTS OUTPUT PATH OF OPTICAL
SIGNAL HAVING PREDETERMINED WAVELENGTH — S1410
BAND ACCORDING TO AMOUNT OF CURRENT
SUPPLIED TO OPTICAL BEAM DETECTOR

CONCAVE DIFFRACTION GRATING HAVING
PREDETERMINED GRATING SPACING REFLECTS
AND DIFFRACTS OPTICAL SIGNAL HAVING
PREDETERMINED WAVELENGTH BAND SUCH — S1420
THAT SINGLE WAVELENGTH OPTICAL SIGNAL
IN PREDETERMINED WAVELENGTH BAND HAS
CONSTRUCTIVE INTERFERENCE

CONSTRUCTIVELY INTERFERED OPTICAL SIGNAL
IS FED BACK TO SOA — S1430

SOA AMPLIFIES AND OUTPUTS CONSTRUCTIVELY
INTERFERED OPTICAL SIGNAL — S1440

END

# FIG. 15

START

FIRST SOA OUTPUTS OPTICAL SIGNAL HAVING PREDETERMINED WAVELENGTH BAND —— S1500

OPTICAL DEFLECTOR OF BEAM STEERING UNIT DEFLECTS OUTPUT PATH OF OPTICAL SIGNAL HAVING PREDETERMINED WAVELENGTH BAND ACCORDING TO AMOUNT OF CURRENT SUPPLIED TO OPTICAL DEFLECTOR —— S1510

CONCAVE DIFFRACTION GRATING HAVING PREDETERMINED GRATING SPACING REFLECTS AND DIFFRACTS THE SIGNAL WAVELENGE OPTICAL SIGNAL SUCH THAT CONSTRUCTIVE INTERFERENCE OCCURS AT THE END LEFT OF LINEAR WAVEGUIDES, WHICH RESPECTIVELY CORRESPOND TO DIFFERENT WAVELENGTHS IN PREDETERMINED WAVELENGTH BAND —— S1520

SECOND SOAs RESPECTIVELY INPUT AT LEAST ONE OPTICAL SIGNAL SEPARATED ACCORDING TO WAVELENGTHS TO CONCAVE DIFFRACTION GRATING —— S1530

AT LEAST SINGLE WAVELENGTH OPTICAL SIGNAL HAVING WAVELENGTH IS FED BACK TO FIRST SOA, WHICH THEN AMPLIFIES AND OUTPUTS AT LEAST SINGLE WAVELENGTH OPTICAL SIGNAL —— S1540

END

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020050121038

- KR 1020060012026

**Non-patent literature cited in the description**

- Continuous Tuning of an Electrically Tunable External-Cavity Semiconductor Laser. *Optics Letters,* 15 August 2000, vol. 25 (16), 165-1167